# EUROPEAN PATENT APPLICATION

(11) **EP 2 413 666 A1**
(43) Date of publication of application: **01.02.2012**
(21) Application number: 10755974.2
(22) Date of filing: 18.03.2010
(51) Int. Cl.: H05B 33/12, H01L 51/50

(54) **ORGANIC EL ELEMENT**

(30) Priority: 25.03.2009 JP 2009074783
(71) Applicant: Panasonic Electric Works Co., Ltd., Kadoma-shi Osaka 571-8686 (JP)
(72) Inventor: SASAKI, Hiroyuki, Kadoma-shi Osaka 571-8686 (JP)
(74) Representative: Appelt, Christian W.
(86) International application number: PCT/JP2010/054700
(87) International publication number: WO 2010/110176

(57) **Abstract**

An organic EL element (1) is formed by laminating two emitting layers (5, 7) between an anode (3) and a cathode (9) with a hole transporting non-emitting layer (6) being interposed between the two emitting layers (5, 7). The emitting layer (5) on an anode side is a hole transporting emitting layer, the emitting layer (7) on a cathode side is an electron transporting emitting layer. The non-emitting layer (6) includes at least one energy transfer auxiliary material in a hole transporting material. In the organic EL element (1), the energy transfer auxiliary material transfers excitation energy in the non-emitting layer (6) to the emitting layers (5, 7) adjacent to the non-emitting layer (6) effectively, so that luminous efficiency of the emitting layers (5, 7) can be enhanced. Moreover, it is difficult for holes to reach an electron transport layer (8), so that the electron transport layer (8) is not deteriorated, and the organic EL element (1) can thereby have a long life.

## Description

### TECHNICAL FIELD

The present invention relates to an organic EL (electroluminescence) element which is used for a flat panel display, a backlight for a liquid crystal display, an illumination light source, etc.

### BACKGROUND ART

An organic EL element has received attention in recent years by reason that a high-brightness flat emission can be achieved by a low voltage of several volts. The organic EL element includes an anode, an emitting layer, and a cathode, and the anode injects holes into the emitting layer and the cathode injects electrons to the emitting layer by applying a voltage, and the injected holes and electrons are coupled to each other in the emitting layer. The organic EL element emits light when excitons, each of which is generated by coupling the hole and the electron, return to their ground state. An emission color of the organic EL element is determined by an emitting material included in the emitting layer. The emitting material which emits light of a single color, that is, blue, green, or red, for example, is currently available.

It is preferable that the organic EL element emits light including plural emission colors when it is used as an illumination light source, and it is preferable that the organic EL element emits light of white color particularly when it is used as an indoor illumination light source. The white color emission includes substantially all of light having wavelength in a visible light region and is obtained by mixing two colors such as light blue and orange, referred to as complementary colors, which complement each other. The organic EL element which emits the light of white color is formed by laminating two emitting layers, each of which provides an emission color which complements the other color, for example.

However, in the organic EL element which is formed by laminating the two emitting layers, the two emitting layers have contact with each other, so that an energy transfer occurs on an interface between the two emitting layers. In particular, excitation energy in an emitting layer which emits light at a short wavelength transfers to an emitting layer which emits light at a long wavelength. Thus, in the above organic EL element, for example, an emission intensity of the emitting layer which emits light of orange color, which has a long wavelength, becomes higher than that of the emitting layer which emits light of light blue color, which has a short wavelength, so that the above organic EL element emits a white light with a tinge of orange color.

Thus, there is a known organic EL element having a layer which does not emit light to block an electrical charge and excitons (refer to Japanese Patent Application Publication No. 2004- 522276, for example). In the above organic EL element, a hole/exciton blocking layer is inserted between two emitting layers which provide different emission colors so that the emission colors are adjusted. The hole/exciton blocking layer blocks a transfer of holes or excitons and enhances an emission intensity of the emitting layer provided on an anode side. However, the hole/exciton blocking layer of the above organic EL element cannot block electrons sufficiently, so that it causes a large chromaticity change.

Moreover, there is also a known organic EL element including two emitting layers which are made up of a hole transporting material and provides different emission colors and a hole barrier layer which is inserted between the two emitting layers (refer to Japanese Patent Application Publication No. 2005- 276583, for example). Although the above organic EL element has high luminous efficiency and has little change in chromaticity, it has a short life by reason that holes deteriorates an electron transport layer which is provided between the emitting layer and a cathode. The deterioration of the electron transport layer is thought to be caused by the feature of the emitting layers that they have a hole transporting property.

### DISCLOSURE OF THE INVENTION

The present invention is to solve the above problems, and an object of the present invention is to provide an organic EL element which has high luminous efficiency, has a long life, and has little change in chromaticity.

An organic EL element according to an aspect of the present invention that is formed by laminating two emitting layers between an anode and a cathode with a hole transporting non-emitting layer interposed between the two emitting layers, wherein the emitting layer on an anode side is a hole transporting emitting layer, the emitting layer on a cathode side is an electron transporting emitting layer, and the non-emitting layer includes at least one energy transfer auxiliary material in a hole transporting material.

According to the above configuration, the energy transfer auxiliary material transfers excitation energy in the non-emitting layer to the emitting layers adjacent to the non-emitting layer effectively, so that the luminous efficiency of the emitting layers can be enhanced. Moreover, it is difficult for holes to reach an electron transport layer, so that the electron transport layer is not deteriorated, and the organic EL element can thereby have the long life.

It is preferable that in the organic EL element, an ionization potential of the hole transporting material in the non-emitting layer is 0.2 eV or more higher than that of a host material of the emitting layer on the cathode side and an electron affinity of the hole transporting material in the non-emitting layer is 0.2 eV or more higher than that of the host material of the emitting layer on the cathode side, and an ionization potential of the energy transfer auxiliary material in the non-emitting layer is higher than that of the hole transporting material in the non-emitting layer and an electron affinity of the energy transfer auxiliary material in the non-emitting layer is lower than that of the hole transporting material in the non-emitting layer.

According to the above configuration, since the hole transporting material in the non-emitting layer and the host material of the emitting layer on the cathode side have the relationship to have the predetermined energy level, the holes and the electrons are easily concentrated on an interface between the non-emitting layer and the emitting layer on the cathode side, and the holes and the electrons do not deteriorate the electron transport layer and a hole transport layer, so that the organic EL element can thereby have the long life. Moreover, since the energy transfer auxiliary material and the hole transporting material in the non-emitting layer have the relationship to have the predetermined energy level, the excitation energy generated in the interface between the non-emitting layer and the emitting layer on the cathode side transfers to the energy transfer auxiliary material effectively, so that the luminous efficiency of the emitting layers adjacent to the non-emitting layer can be enhanced.

It is preferable that the organic EL element includes: a hole transport layer which is located between the anode and the emitting layer on the anode side; and an electron transport layer which is located between the cathode and the emitting layer on the cathode side, wherein a mobility of electrons in the electron transport layer is higher than a mobility of holes in the hole transport layer.

According to the above configuration, since the electrons pass through the non-emitting layer and reach the emitting layer on the anode side, the light emission from the emitting layer on the anode side can sufficiently be achieved, and the emitting layers adjacent to the non-emitting layer can emit the light in an appropriate balance, so that the chromaticity change is reduced.

It is preferable that in the organic EL element, a material of the hole transporting material in the non-emitting layer is identical with a material of the hole transport layer.

According to the above configuration, the hole transporting material in the non-emitting layer and the hole transport layer are made of the same material, so that a manufacturing process is simplified.

An organic EL element according to another aspect of the present invention that is formed by laminating two emitting layers between an anode and a cathode with an electron transporting non-emitting layer being interposed between the two emitting layers, wherein the emitting layer on an anode side is a hole transporting emitting layer, the emitting layer on a cathode side is an electron transporting emitting layer, and the non-emitting layer includes at least one energy transfer auxiliary material in an electron transporting material.

According to the above configuration, the energy transfer auxiliary material transfers the excitation energy in the non-emitting layer to the emitting layers adjacent to the non-emitting layer effectively, so that the luminous efficiency of the emitting layers can be enhanced. Moreover, it is difficult for the electrons to reach a hole transport layer, so that the hole transport layer is not deteriorated, and the organic EL element can thereby have the long life.

It is preferable that in the organic EL element, an ionization potential of the electron transporting material in the non-emitting layer is 0.2 eV or more lower than that of a host material of the emitting layer on the anode side and an electron affinity of the electron transporting material in the non-emitting layer is 0.2 eV or more lower than that of the host material of the emitting layer on the anode side, and an ionization potential of the energy transfer auxiliary material in the non-emitting layer is higher than that of the electron transporting material in the non-emitting layer and an electron affinity of the energy transfer auxiliary material in the non-emitting layer is lower than that of the electron transporting material in the non-emitting layer.

According to the above configuration, since the electron transporting material in the non-emitting layer and the host material of the emitting layer on the anode side have the relationship to have the predetermined energy level, the holes and the electrons are easily concentrated on an interface between the non-emitting layer and the emitting layer on the anode side, and the holes and the electrons do not deteriorate an electron transport layer and the hole transport layer, so that the organic EL element can thereby have the long life. Moreover, since the energy transfer auxiliary material and the hole transporting material in the non-emitting layer have the relationship to have the predetermined energy level, the excitation energy generated in the interface between the non-emitting layer and the emitting layer on the anode side transfers to the energy transfer auxiliary material effectively, so that the luminous efficiency of the emitting layers adjacent to the non-emitting layer can be enhanced.

It is preferable that the organic EL element includes: a hole transport layer which is located between the anode and the emitting layer on the anode side; and an electron transport layer which is located between the cathode and the emitting layer on the cathode side, wherein a mobility of electrons in the electron transport layer is lower than a mobility of holes in the hole transport layer.

According to the above configuration, since the holes pass through the non-emitting layer and reach the emitting layer on the cathode side, the light emission from the emitting layer on the cathode side can sufficiently be achieved, and the emitting layers adjacent to the non-emitting layer can emit the light in an appropriate balance, so that the chromaticity change is reduced.

It is preferable that in the organic EL element, the energy transfer auxiliary material in the non-emitting layer includes at least an emitting dopant and a maximum emission wavelength of the emitting dopant in the energy transfer auxiliary material is shorter than that of at least one emitting dopant included in the emitting layers on the anode and cathode sides.

According to the above configuration, the emitting dopant in the energy transfer auxiliary material transfers the excitation energy in the non-emitting layer to the emitting layers adjacent to the non-emitting layer effectively, so that the luminous efficiency of the emitting layers can be further enhanced.

It is preferable that in the organic EL element, a thickness of the non-emitting layer is 1 to 5 nm.

According to the above configuration, when the non-emitting layer has a hole transporting property, the electrons which reach the emitting layer on the anode side increase by making the non-emitting layer thin, so that the light emission from the emitting layer on the anode side can sufficiently be achieved, and the emitting layers adjacent to the non-emitting layer can emit the light in an appropriate balance, thus color deviation is reduced. Moreover, when the non-emitting layer has an electron transporting property, the holes which reach the emitting layer on the cathode side increase by making the non-emitting layer thin, so that the light emission from the emitting layer on the cathode side can sufficiently be achieved, and the emitting layers adjacent to the non-emitting layer can emit the light in an appropriate balance, thus color deviation is reduced.

It is preferable that in the organic EL element, the emitting layer on the anode side emits light of a maximum emission wavelength within a range of 600 to 650 nm and the emitting layer of the cathode side emits light of a maximum emission wavelength within a range of 450 to 490 nm.

According to the above configuration, the emitting layers are adapted to satisfy easily an optical design, so that the light can easily be extracted from the substrate.

### BRIEF DESCRIPTION OF THE DRAWING

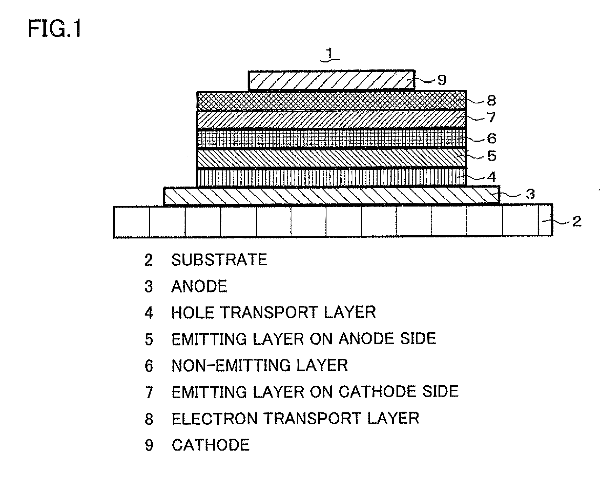

FIG 1 is a sectional side view of an organic EL element according to a preferred embodiment of the present invention.

### DESCRIPTION OF THE PREFERRED EMBODIMENT(S)

An organic EL element according to a preferred embodiment of the present invention is described with reference to FIG 1. FIG. 1 shows a configuration of an organic EL element 1 of the present preferred embodiment. The organic EL element 1 includes two emitting layers 5 and 7 between an anode 3 and a cathode 9 with a non-emitting layer 6 being interposed between the emitting layers 5 and 7. In particular, the organic EL element 1 is formed by laminating, in order from a substrate 2 side, the anode 3, a hole transport layer 4, the emitting layer 5 located on the anode side, the non-emitting layer 6, the emitting layer 7 located on the cathode side, an electron transport layer 8, and the cathode 9 on a substrate 2.

The substrate 2 has a translucency, and a transparent glass plate, which includes a soda-lime glass or a non-alkali glass, or a plastic film or a plastic plate, which is made of polyester, polyolefin, polyamide, epoxy resin, or fluorine contained resin, for example, is used as a material of the substrate 2.

The anode 3, which has a translucency, is an electrode to inject holes into the emitting layers 5 and 7. A material of the anode 3 includes, for example, metals such as gold, CuI, ITO (Indium Tin Oxide), SnO₂, ZnO, IZO (Indium Zinc Oxide), PEDOT, conductive polymers such as polyaniline, conductive polymers doped with an arbitrary acceptor, light transmissive conductive materials such as carbon nanotubes or the like. The anode 3, the emitting layers 5 and 7, the non-emitting layer 6, and the cathode 9, etc. are laminated by vacuum deposition, sputtering or applying, for example.

The cathode 9 is an electrode to inject electrons into the emitting layers 5 and 7. A material of the cathode 9 includes, for example, alkali metals, alkali metal halides, alkali metal oxides, alkali earth metals, and alloys of the above materials and other metals, which are, in particular, sodium, sodium-pottasium alloy, lithium, magnesium, magnesium-silver mixture, magnesium-indium mixture, aluminum-lithium alloy, Al/LiF mixture, etc. Moreover, the material of the cathode 9 includes aluminum, Al/Al₂O₃ mixture, alkali metal oxides, alkali metal halides, or any composition having at least one layer of a conductive material such as a metal laminated on a ground made up of metal oxides, which are, in particular, alkali metal/Al laminates, alkali metal halide/alkali earth metal/Al laminates, alkali metal oxide/Al laminates, etc.

The hole transport layer 4 is located between the anode 3 and the emitting layer 5 on the anode side and enhances a hole injection into the emitting layers 5 and 7. Any compound which has a hole transporting property may be used as a material of the hole transport layer 4, and the following are examples of the compound: N,N'-Bis(1-naphthyl)-N,N'-diphenyl-4,4-biphenyl (NPD); N,N'-Bis(naphthalen-1-yl)-N,N'-bis(phenyl)-benzidine (NPB); N,N'-Bis(3-methylphenyl)-N,N'-bis(phenyl)-benzidine (TPD); 2,2',7,7'-Tetyakis(N,N-diphenylamino)-9,9'-spirobifluorene (Sprio TAD); and N,N'-Bis(3-methylphenyl)-N,N'-bis(phenyl)-9,9'-dimethyl-fluorene (DMFL-TPD).

The electron transport layer 8 is located between the cathode 9 and the emitting layer 7 on the cathode side and enhances an electron injection into the emitting layers 5 and 7. A material of the electron transport layer 8 includes Tris(8-hydroxy-quinolinato)aluminum (Alq₃), 4,4'-Bis(carbazol-9-yl)biphenyl (CBP), 4,4'-Bis(9-carbazolyl)-2,2'-dimethyl-biphenyl (CDBP), or the like, for example.

Furthermore, it is preferable that a mobility of the electrons in the electron transport layer 8 is higher than a mobility of the holes in the hole transport layer 4. In this case, a combination of the materials of the hole transport layer 4 and the electron transport layer 8 includes a combination of NPD and Alq₃ to which 4,7-Diphenyl-1,10-phenathroline (Bphen) is added, for example. In the organic EL element 1, the electrons pass through the non-emitting layer 6 and reach the emitting layer 5 on the anode side, the light emission from the emitting layer 5 on the anode side can sufficiently be achieved, and the emitting layers 5 and 7 located on both sides of the non-emitting layer 6 can emit the light in an appropriate balance, so that the chromaticity change is reduced.

The emitting layer 5 on the anode side is a hole transporting emitting layer and is made up of a hole transporting host material and an emitting dopant included in the host material. Any compound which has the hole transporting property may be used as the host material of the emitting layer 5 on the anode side, and the material is the same as that of the hole transport layer 4 described above, for example. An emitting material is used as the emitting dopant of the emitting layer 5 on the anode side so that an emission color of the emitting material and an emission color of the emitting dopant included in the emitting layer 7 on the cathode side complement each other.

The emitting layer 7 on the cathode side is an electron transporting emitting layer and is made up of an electron transporting host material and an emitting dopant included in the host material. Any compound which has the electron transporting property may be used as the electron transporting host material of the emitting layer 7 on the cathode side, and the material is the same as that of the electron transport layer 8 described above, for example. An emitting material is used as the emitting dopant of the emitting layer 7 on the cathode side so that an emission color of the emitting material and an emission color of the emitting dopant included in the emitting layer 5 on the anode side complement each other. Due to the emitting layer 7 on the cathode side which has the electron transporting property, it is difficult for the holes to reach the electron transport layer 8, so that the electron transport layer 8 is not deteriorated, and the organic EL element 1 can thereby have a long life.

Considering an optical design, it is preferable that the emitting layer 5 on the anode side emits light of a maximum emission wavelength within a range of 600 to 650 nm and the emitting layer 7 of the cathode side emits light of a maximum emission wavelength within a range of 450 to 490 nm. The optical design means that a film thickness and a film configuration of the organic EL element 1 are adapted to satisfy a related equation of nd = λ/4 so that the light generated in the emitting layers 5 and 7 can effectively be extracted from the substrate 2. In the above equation, n indicates a refraction index of the organic material such as the emitting layers 5 and 7, d indicates a film thickness obtained by measuring a distance from an emission center (a center of a recombination region of the holes and the electrons) to the cathode 9, and λ indicates the maximum emission wavelength of the emitting dopant. When three primary colors of blue, green, and red are considered, the maximum emission wavelength of the red color is the longest, and the maximum emission wavelength of the blue color is the shortest. Thus, in the organic EL element 1, the emitting layer 5 on the anode side which is located away from the cathode 9 emits light of red color, whose maximum emission wavelength is within 600 to 650 nm, and the emitting layer 7 on the cathode side which is located near the cathode 9 emits light of blue color, whose maximum emission wavelength is within 450 to 490 nm, so that the related equation of nd = λ/4 can easily be satisfied. Since the configuration of the organic EL element 1 causes the emitting layers 5 and 7 to satisfy easily the optical design, the light can easily be extracted from the substrate 2.

The non-emitting layer 6 has the hole transporting property and includes at least one energy transfer auxiliary material in a hole transporting material. Since the energy transfer auxiliary material transfers an excitation energy in the non-emitting layer 6 to the emitting layers 5 and 7 adjacent to the non-emitting layer 6 effectively, so that luminous efficiency of the emitting layers 5 and 7 can be enhanced. Any compound which has the hole transporting property may be used as the hole transporting material in the non-emitting layer 6, and the material is the same as that of the hole transport layer 4 described above, for example. Moreover it is preferable that the hole transporting material in the non-emitting layer 6 is the same as the material of the hole transport layer 4. In this case, a manufacturing process of the organic EL element 1 is simplified.

It is preferable that the energy transfer auxiliary material in the non-emitting layer 6 includes at least an emitting dopant. The maximum emission wavelength of the emitting dopant in the energy transfer auxiliary material is shorter than that of at least one emitting dopant included in the emitting layers 5 and 7 and is selected from 3-(2-Benzothiazolyl)-7-(diethylamino)coumarin (coumarine 6), N,N'-Dimethyl-quinacridone (DMQA), Tetraphenylnaphthacene (Rubrene), 2,8-di-tert-butyl-5,11-bis(4-tert-butylphenyl)-6,12-diphenyltetracene (TBRb), for example. The emitting dopant in the energy transfer auxiliary material efficiently transfers the excitation energy in the non-emitting layer 6 to the emitting layers 5 and 7 adjacent to the non-emitting layer 6. Thus, the non-emitting layer 6 does not emit the light, so that the luminous efficiency of the emitting layers 5 and 7 can be further enhanced.

It is preferable that both an ionization potential and an electron affinity of the hole transporting material in the non-emitting layer 6 are 0.2 eV or more higher than those of the host material of the emitting layer 7 on the cathode side. Since the hole transporting material in the non-emitting layer 6 and the host material of the emitting layer 7 on the cathode side have the relationship to have the above energy level, the holes and the electrons are easily concentrated on an interface between the non-emitting layer 6 and the emitting layer 7 on the cathode side, and the holes and the electrons do not deteriorate the electron transport layer 8 and the hole transport layer 4, so that the organic EL element 1 can thereby have the long life.

Moreover, it is preferable that in the non-emitting layer 6, the ionization potential of the energy transfer auxiliary material is higher than that of the hole transporting material and the electron affinity of the energy transfer auxiliary material is lower than that of the hole transporting material. In the organic EL element 1, the energy transfer auxiliary material and the hole transporting material in the non-emitting layer 6 have the relationship to have the above energy level, so that the excitation energy generated in the interface between the non-emitting layer 6 and the emitting layer 7 on the cathode side transfers to the energy transfer auxiliary material effectively. Thus, the luminous efficiency of the emitting layers 5 and 7 adjacent to the non-emitting layer 6 can be enhanced. A combination of the hole transporting material in the non-emitting layer 6, the energy transfer auxiliary material in the non-emitting layer 6, and the host material in the emitting layer 7 on the cathode side includes a combination of TPD, coumarine 6, and CBP, for example.

It is preferable that a thickness of the non-emitting layer 6 is 1 to 5 nm. In the organic EL element 1, the electrons which reach the emitting layer 5 on the anode side increase by making the non-emitting layer 6 thin, so that the light emission from the emitting layer 5 on the anode side can sufficiently be achieved. Thus, the emitting layers 5 and 7 adjacent to the non-emitting layer 6 can emit the light in the appropriate balance, and the chromaticity change is reduced.

### (Modification Example)

A modification example of the organic EL element 1 is described below. The organic EL element 1 of the modification example differs from that of the above preferred embodiment in that the non-emitting layer 6 has the electron transporting property instead of the hole transporting property and at least one energy transfer auxiliary material is included in the electron transporting material in the non-emitting layer 6. In the organic EL element 1, the energy transfer auxiliary material transfers the excitation energy in the non-emitting layer 6 to the emitting layers 5 and 7 adjacent to the non-emitting layer 6 effectively, so that the luminous efficiency of the emitting layers 5 and 7 can be enhanced. Moreover, due to the emitting layer 5 on the anode side which has the hole transporting property, it is difficult for the electrons to reach the hole transport layer 4, so that the hole transport layer 4 is not deteriorated, and the organic EL element 1 can thereby have the long life.

It is preferable that both an ionization potential and an electron affinity of the electron transporting material in the non-emitting layer 6 are 0.2 eV or more lower than those of the host material of the emitting layer 5 on the anode side. Since the electron transporting material in the non-emitting layer 6 and the host material of the emitting layer 5 on the anode side have the relationship to have the above energy level, the holes and the electrons are easily concentrated on an interface between the non-emitting layer 6 and the emitting layer 5 on the anode side, and the holes and the electrons do not deteriorate the electron transport layer 8 and the hole transport layer 4, so that the organic EL element 1 can thereby have the long life.

Moreover, it is preferable that in the non-emitting layer 6, the ionization potential of the energy transfer auxiliary material is higher than that of the electron transporting material and the electron affinity of the energy transfer auxiliary material is lower than that of the electron transporting material. In the organic EL element 1, the energy transfer auxiliary material and the electron transporting material in the non-emitting layer 6 have the relationship to have the above energy level, so that the excitation energy generated in the interface between the non-emitting layer 6 and the emitting layer 5 on the anode side transfers to the energy transfer auxiliary material effectively, and thus, the luminous efficiency of the emitting layers 5 and 7 adjacent to the non-emitting layer 6 can be enhanced.

Furthermore, it is preferable that the mobility of the electrons in the electron transport layer 8 is lower than the mobility of the holes in the hole transport layer 4. In the organic EL element 1, the electrons pass through the non-emitting layer 6 and reach the emitting layer 7 on the cathode side, the light emission from the emitting layer 7 on the cathode side can sufficiently be achieved, and the emitting layers 5 and 7 located on both sides of the non-emitting layer 6 can emit the light in the appropriate balance, so that the chromaticity change is reduced.

Next, working examples 1 to 8 and comparison examples 1 to 5 of the organic EL element 1 according to the present preferred embodiment is described below.

### (Working Example 1)

The organic EL element 1 is formed by laminating, in order from the substrate 2 side, the anode 3, the hole transport layer 4, the emitting layer 5 on the anode side which is made of the host material and the emitting dopant, the non-emitting layer 6 which is made of the hole transporting material and the energy transfer auxiliary material, the emitting layer 7 on the cathode side which is made of the host material and the emitting dopant, the electron transport layer 8, and the cathode 9 on the substrate 2. Materials of the respective layers are as follows: the substrate 2 is made of alkali-free glass; the anode 3 is made of ITO; the hole transport layer 4 is made of NPD; the host material of the emitting layer 5 on the anode side is NPD; the emitting dopant of the emitting layer 5 on the anode side is 2-methyl-6-[2-(2,3,6,7-tetrahydro-1H,5H-benzo[ij]quinolizin-9-yl)ethenyl] -4H-pyran-4-ylidene]propane-dinitrile (DCM2); the hole transporting material of the non-emitting layer 6 is TPD; the energy transfer auxiliary material of the non-emitting layer 6 is coumarine 6; the host material of the emitting layer 7 on the cathode side is CBP; the emitting dopant of the emitting layer 7 on the cathode side is 2,5,8,11-tetra-tert-butylperylene (TBPe); the electron transport layer 8 is made of Alq₃; and the cathode 9 is made of Al/LiF. Thicknesses of the respective layers are as follows: the substrate 2 is 0.7 mm, the anode 3 is 150 nm, the hole transport layer 4 is 40 nm, the emitting layer 5 on the anode side is 20 nm, the non-emitting layer 6 is 5 nm, the emitting layer 7 on the cathode side is 30 nm, the electron transport layer 8 is 30 nm, Al of the cathode 9 is 80 nm, LiF of the cathode 9 is 1 nm.

### (Working Example 2)

The organic EL element 1 is obtained in a manner similar to the working example 1 except that the energy transfer auxiliary material of the non-emitting layer 6 is ruburene.

### (Working Example 3)

The organic EL element 1 is obtained in a manner similar to the working example 1 except that the hole transporting material of the non-emitting layer 6 is made of NPD, which is the same material as that used as the host material of the emitting layer 5 on the anode side.

### (Comparison Example 1)

An organic EL element is obtained in a manner similar to the working example 1 except that the non-emitting layer 6 is made up of only the hole transporting material without adding the energy transfer auxiliary material.

### (Comparison Example 2)

An organic EL element is obtained in a manner similar to the working example 1 except that the energy transfer auxiliary material of the non-emitting layer 6 is 4,4'-(bis(9-ethyl-3-carbazovinylene)-1,1'-biphenyl (BCzVBi) and the host material of the emitting layer 7 on the cathode side is NPD, which has the hole transporting property.

### (Comparison Example 3)

An organic EL element is obtained in a manner similar to the working example 1 except that the host material of the emitting layer 7 on the cathode side is NPD, which has the hole transporting property.

Each sample of the working examples 1 to 3 and the comparison examples 1 to 3 produced in the manner described above is connected to a power supply (KEYTHLEY 2400) so that constant current having current density of 10 mA/cm² is applied to each sample, and power efficiency is measured using an integrating sphere (product name: SLMS-CDS manufactured by Labsphere, Inc.). Moreover, half-luminance lifetime, which means a time for the luminance to decrease by half, is measured using a luminance meter (product name: LS-110 manufactured by Konica Minolta Holdings, Inc.) by making each sample emit the light continuously at the same current density and measuring luminance of the light. A measurement result is shown in a table 1 below. The power efficiency and the lifetime in the comparison example 1 are used as standards and their values are set to 1.0.

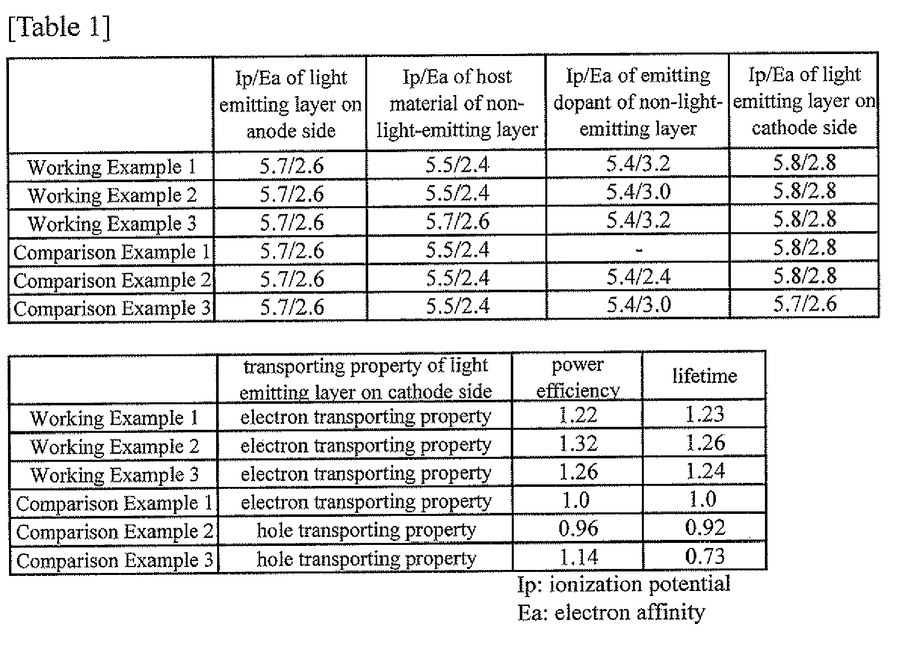

As is obvious from the measurement result of the power efficiency and the lifetime of each sample according to the working examples 1 to 3 and the comparison examples 1 to 3, the organic EL elements 1 of the working examples 1 to 3 have the high power efficiency, so that they have the high luminous efficiency and the long life.

### (Working Example 4)

The organic EL element 1 is obtained in a manner similar to the working example 1 except that the thickness of the non-emitting layer 6 is 1 nm.

### (Working Example 5)

The organic EL element 1 is obtained in a manner similar to the working example 1 except that the thickness of the non-emitting layer 6 is 3 nm.

### (Comparison Example 4)

An organic EL element is obtained in a manner similar to the working example 1 except that the thickness of the non-emitting layer 6 is 7 nm.

The power efficiency and the lifetime of each sample of the working examples 1, 4 and 5 and the comparison examples 1 and 4 produced in the manner described above are measured in the same manner as the above description. Moreover, each sample is connected to a power supply (KEYTHLEY 2400) so that constant current having current density of 10 mA/cm² is applied to each sample, and chromaticity change is measured using a luminance meter (product name: LS-110 manufactured by Konica Minolta Holdings, Inc.) by making each sample emit the light continuously and measuring luminance and chromaticity of the light. A measurement result is shown in a table 2 below. The power efficiency, the lifetime, and the color deviation of the comparison example 1 are used as standards, and the values of the power efficiency and the lifetime are set to 1.0 and the value of the color deviation is set to 0.

**[Table 2]**

| | power efficiency | lifetime | color deviation from comparison example 1 | |
|---|---|---|---|---|
| | | | CIE-x | CIE-y |
| Working Example 1 | 1.22 | 1.23 | +0.007 | +0.010 |
| Working Example 4 | 1.16 | 1.04 | 0 | 0 |
| Working Example 5 | 1.20 | 1.17 | +0.004 | +0.006 |
| Comparison Example 1 | 1.0 | 1.0 | 0 | 0 |
| Comparison Example 4 | 1.26 | 0.98 | +0.012 | +0.019 |

As is obvious from the measurement result of the power efficiency, the lifetime, and the color deviation of each sample according to the working examples 1, 4, and 5 and the comparison examples 1 and 4, the organic EL elements 1 of the working examples 1, 4, and 5 have the high power efficiency, so that they have the high luminous efficiency and the long life. Moreover, in the organic EL elements 1 of the working examples 1, 4, and 5, the color deviation is reduced, thus the chromaticity change is reduced.

### (Working Example 6)

The organic EL element 1 is obtained in a manner similar to the working example 1 except that the material of the electron transport layer 8 is Alq₃ and Bphen, a ratio between Alq₃ and Bphen is 10 to 1, and the mobility of the electrons in the electron transport layer 8 is higher than the mobility of the holes in the hole transport layer 4.

The power efficiency and the lifetime of each sample of the working examples 1 and 6 produced in the manner described above are measured in the same manner as the above description and moreover, the mobility of the holes in the hole transport layer 4 and the mobility of the electrons in the electron transport layer 8 are measured. A measurement result is shown in a table 3 below. The power efficiency and the lifetime in the comparison example 1 are used as standards and their values are set to 1.0.

**[Table 3]**

| | hole mobility of hole transporting layer (cm²/Vs) | electron mobility of electron transporting layer (cm²/Vs) | power efficiency | lifetime |
|---|---|---|---|---|
| Working Example 1 | 3E-6 | 7E-7 | 1.22 | 1.23 |
| Working Example 6 | 3E-6 | 5E-6 | 1.41 | 1.35 |

As is obvious from the measurement result of the power efficiency and the lifetime of each sample according to the working examples 1 and 6, the organic EL element 1 of the working example 6 has the high power efficiency compared to the organic EL element 1 of the working example 1, so that the organic EL element 1 of the working example 6 has the high luminous efficiency and the long life.

### (Working Example 7)

The organic EL element 1 is obtained in a manner similar to the working example 1 except that the hole transporting material the non-emitting layer 6 is (1,1'-Bisphenyl-4-olato)bis(2-methl-8-quinolinplate-N1,08)Aluminum (BAlq), which has an electron transporting property, and the energy transfer auxiliary material of the non-emitting layer 6 is ruburene.

### (Working Example 8)

The organic EL element 1 is obtained in a manner similar to the working example 7 except that the material of the electron transport layer 8 is Alq₃ and Bphen, a ratio between Alq₃ and Bphen is 10 to 1, and the mobility of the electrons in the electron transport layer 8 is higher than the mobility of the holes in the hole transport layer 4.

### (Comparison Example 5)

An organic EL element is obtained in a manner similar to the working example 7 except that the non-emitting layer 6 is made up of only the electron transporting material without adding the energy transfer auxiliary material.

The power efficiency and the lifetime of each sample of the working examples 7 and 8 and the comparison example 5 produced in the manner described above, the mobility of holes in the hole transport layer 4, and the mobility of the electrons in the electron transport layer 8 are measured in the same manner as the above description. A measurement result is shown in a table 4 below. The power efficiency and the lifetime in the comparison example 5 are used as standards and their values are set to 1.0.

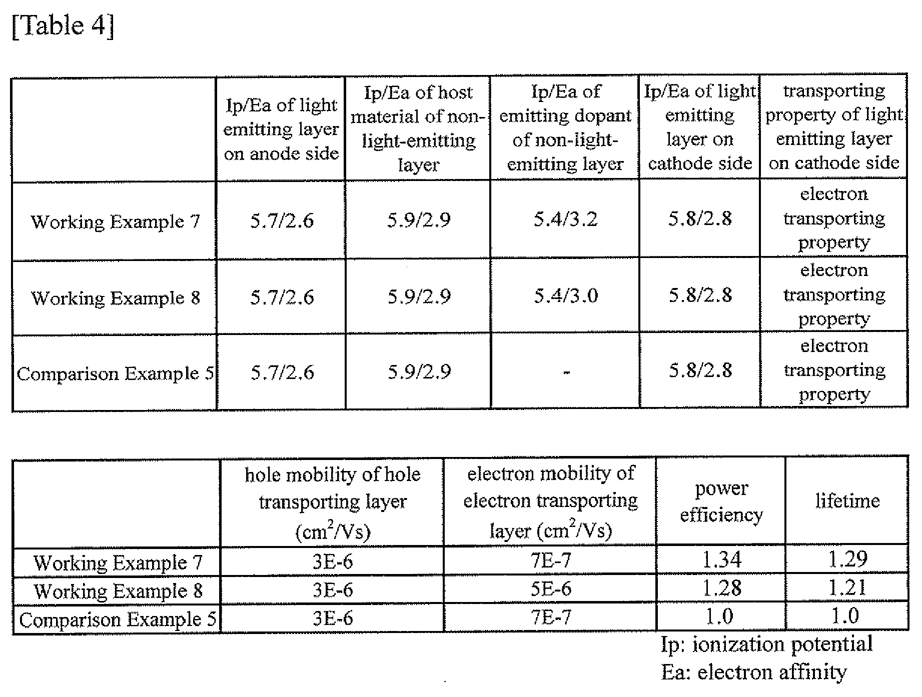

As is obvious from the measurement result of the power efficiency and the lifetime of each sample according to the working examples 7 and 8 and the comparison example 5, the organic EL elements 1 of the working examples 7 and 8 have the high power efficiency and thus have the high luminous efficiency and the long life. Moreover, the organic EL element 1 of the working example 7 has the high power efficiency compared to the organic EL element 1 of the working example 8, so that the organic EL element 1 of the working example 7 has the high luminous efficiency and the long life.

The present invention is not limited to the configuration of the above preferred embodiment, however, various modification are applicable without departing from the scope of the invention. For example, on organic EL element may be provided with an electron injection layer which enhances an electron injection efficiency from a cathode between the cathode and an electron transport layer and a hole injection layer which enhances a hole injection efficiency from an anode between the anode and a hole transport layer.

The present invention is based on Japanese Patent Application No. 2009- 74783, and as a result, the subject matter is to be combined with the present invention with reference to the specification and drawings of the above patent application.

Although the present invention is fully described by the preferred embodiments with reference to the accompanying drawings, it is clear to the person having ordinary skill in the art that the various changes and modifications are applicable. Consequently, such changes and modifications do not depart from the scope of the present invention but are to be included in the scope of the present invention.

## Claims

1. An organic EL element that is formed by laminating two emitting layers between an anode and a cathode with a hole transporting non-emitting layer interposed between the two emitting layers, wherein
the emitting layer on an anode side is a hole transporting emitting layer,
the emitting layer on a cathode side is an electron transporting emitting layer, and
the non-emitting layer includes at least one energy transfer auxiliary material in a hole transporting material.

2. The organic EL element according to claim 1, wherein
an ionization potential of the hole transporting material in the non-emitting layer is 0.2 eV or more higher than that of a host material of the emitting layer on the cathode side and an electron affinity of the hole transporting material in the non-emitting layer is 0.2 eV or more higher than that of the host material of the emitting layer on the cathode side and
an ionization potential of the energy transfer auxiliary material in the non-emitting layer is higher than that of the hole transporting material in the non-emitting layer and an electron affinity of the energy transfer auxiliary material in the non-emitting layer is lower than that of the hole transporting material in the non-emitting layer.

3. The organic EL element according to claim 2, comprising:
a hole transport layer which is located between the anode and the emitting layer on the anode side and
an electron transport layer which is located between the cathode and the emitting layer on the cathode side, wherein
a mobility of electrons in the electron transport layer is higher than a mobility of hosts in the hole transport layer.

4. The organic EL element according to claim 3, wherein
a material of the hole transporting material in the non-emitting layer is identical with a material of the hole transport layer.

5. The organic EL element according to claim 4, wherein
the energy transfer auxiliary material in the non-emitting layer includes at least an emitting dopant and
a maximum emission wavelength of the emitting dopant in the energy transfer auxiliary material is shorter than that of at least one emitting dopant included in the emitting layers on the anode and cathode sides.

6. The organic EL element according to claim 5, wherein
a thickness of the non-emitting layer is 1 to 5 nm.

7. The organic EL element according to claim 5, wherein
the emitting layer on the anode side emits light of a maximum emission wavelength within a range of 600 to 650 nm and
the emitting layer of the cathode side emits light of a maximum emission wavelength within a range of 450 to 490 nm.

8. The organic EL element according to claim 1, comprising:
a hole transport layer which is located between the anode and the emitting layer on the anode side and
an electron transport layer which is located between the cathode and the emitting layer on the cathode side, wherein
a mobility of electrons in the electron transport layer is higher than a mobility of holes in the hole transport layer.

9. The organic EL element according to claim 1, wherein
the energy transfer auxiliary material in the non-emitting layer includes at least an emitting dopant and
a maximum emission wavelength of the emitting dopant in the energy transfer auxiliary material is shorter than that of at least one emitting dopant included in the emitting layers on the anode and cathode sides.

10. The organic EL element according to claim 2, wherein
the energy transfer auxiliary material in the non-emitting layer includes at least an emitting dopant and
a maximum emission wavelength of the emitting dopant in the energy transfer auxiliary material is shorter than that of at least one emitting dopant included in the emitting layers on the anode and cathode sides.

11. An organic EL element that is formed by laminating two emitting layers between an anode and a cathode with an electron transporting non-emitting layer being interposed between the two emitting layers, wherein
the emitting layer on an anode side is a hole transporting emitting layer,
the emitting layer on a cathode side is an electron transporting emitting layer, and
the non-emitting layer includes at least one energy transfer auxiliary material in an electron transporting material.

12. The organic EL element according to claim 11, wherein
an ionization potential of the electron transporting material in the non-emitting layer is 0.2 eV or more lower than that of a host material of the emitting layer on the anode side and an electron affinity of the electron transporting material in the non-emitting layer is 0.2 eV or more lower than that of the host material of the emitting layer on the anode side and
an ionization potential of the energy transfer auxiliary material in the non-emitting layer is higher than that of the electron transporting material in the non-emitting layer and an electron affinity of the energy transfer auxiliary material in the non-emitting layer is lower than that of the electron transporting material in the non-emitting layer.

13. The organic EL element according to claim 12, comprising:
a hole transport layer which is located between the anode and the emitting layer on the anode side and
an electron transport layer which is located between the cathode and the emitting layer on the cathode side, wherein
a mobility of electrons in the electron transport layer is lower than a mobility of holes in the hole transport layer.

14. The organic EL element according to claim 13, wherein
the energy transfer auxiliary material in the non-emitting layer includes at least an emitting dopant and
a maximum emission wavelength of the emitting dopant in the energy transfer auxiliary material is shorter than that of at least one emitting dopant included in the emitting layers on the anode and cathode sides.

15. The organic EL element according to claim 14, wherein
a thickness of the non-emitting layer is 1 to 5 nm.

16. The organic EL element according to claim 14, wherein
the emitting layer on the anode side emits light of a maximum emission wavelength within a range of 600 to 650 nm and
the emitting layer of the cathode side emits light of a maximum emission wavelength within a range of 450 to 490 nm.

17. The organic EL element according to claim 11, comprising:
a hole transport layer which is located between the anode and the emitting layer on the anode side and
an electron transport layer which is located between the cathode and the emitting layer on the cathode side, wherein
a mobility of electrons the electron transport layer is lower than a mobility holes of the hole transport layer.

18. The organic EL element according to claim 11, wherein
the energy transfer auxiliary material in the non-emitting layer includes at least an emitting dopant and
a maximum emission wavelength of the emitting dopant in the energy transfer auxiliary material is shorter than that of at least one emitting dopant included in the emitting layers on the anode and cathode sides.

19. The organic EL element according to claim 12, wherein
the energy transfer auxiliary material in the non-emitting layer includes at least an emitting dopant and
a maximum emission wavelength of the emitting dopant in the energy transfer auxiliary material is shorter than that of at least one emitting dopant included in the emitting layers on the anode and cathode sides.
